# EUROPÄISCHE PATENTSCHRIFT

(11) **EP 2 862 271 B1**
(45) Veröffentlichungstag und Bekanntmachung des Hinweises auf die Patenterteilung: **31.10.2018**
(21) Anmeldenummer: 13729935.0
(22) Anmeldetag: 12.06.2013
(51) Int. Cl.: H03F 1/02, H03F 1/32, H03F 3/19, H03F 3/21, H03G 3/30

(54) **VERSTÄRKERANORDNUNG**
AMPLIFIER ASSEMBLY
ENSEMBLE AMPLIFICATEUR

(30) Priorität: 18.06.2012 DE 102012210249
(43) Veröffentlichungstag der Anmeldung: 22.04.2015
(73) Patentinhaber: RWTH Aachen, 52062 Aachen (DE)
(72) Erfinder: Negra, Renato, 52074 Aachen (DE); Aref, Ahmed, 52134 Herzogenrath (DE)
(74) Vertreter: RCD Patent Giesen, Schmelcher & Griebel Patentwanwälte PartG mbB
(86) Internationale Anmeldenummer: PCT/EP2013/062105
(87) Internationale Veröffentlichungsnummer: WO 2013/189793

(56) Entgegenhaltungen:
- EP-A1- 1 881 597
- WO-A1-2011/097387
- JUNQING GUAN ET AL: "System-level performance study of a multistandard outphasing transmitter using optimised multilevels", MICROWAVE SYMPOSIUM DIGEST (MTT), 2011 IEEE MTT-S INTERNATIONAL, IEEE, 5. Juni 2011 (2011-06-05), Seiten 1-4, XP032006834, DOI: 10.1109/MWSYM.2011.5972887 ISBN: 978-1-61284-754-2
- KAI-YUAN JHENG ET AL: "Multilevel Linc System Design for Power Efficiency Enhancement", SIGNAL PROCESSING SYSTEMS, 2007 IEEE WORKSHOP ON, IEEE, PI, 17. Oktober 2007 (2007-10-17), Seiten 31-34, XP031572975, ISBN: 978-1-4244-1221-1
- AHMED BIRAFANE ET AL: "Analyzing LINC Systems", IEEE MICROWAVE MAGAZINE, IEEESERVICE CENTER, PISCATAWAY, NJ, US, vol. 11, no. 5, 1 August 2010 (2010-08-01) , pages 59-71, XP011312820, ISSN: 1527-3342

## Beschreibung

Die Erfindung betrifft eine Verstärkeranordnung.

### Hintergrund der Erfindung

In vielen Bereichen der drahtlosen Kommunikationstechnik ist die Linearität des Übertragungsverhaltens eine der Kernforderungen. Insbesondere bei digitalen Übertragungssystemen ist dies von eminenter Wichtigkeit.

Nichtlinearitäten in Sendern begünstigen unerwünschte Aussendungen, welche die Verbindungsqualität von anderen Teilnehmern bzw. anderen Übertragungsdiensten beeinträchtigen. Zudem werden durch die Nichtlinearitäten Verzerrungen bewirkt, die sich negativ auf die Qualität der eigenen Verbindung auswirken.

Bisher wurde diesem Problem dadurch begegnet, dass die Hochfrequenz-Endstufen gegenüber der mittleren Ausgangsleistung überdimensioniert wurden. So z.B. sind Ausgangsleistungsreserven ("Back-off") von 10 dB oder mehr keine Seltenheit, um die geforderte Linearität sicherzustellen.

Diese Überdimensionierung des Systems hat zahlreiche Nachteile. Zum einen sind die Herstellungskosten höher. Zum anderen ist die Leistungsausbeute gering, d.h. der Wirkungsgrad eines Senders nimmt mit zunehmenden Back-off rapide ab. Mit sinkendem Wirkungsgrad steigt die Verlustleistung an. Um die dabei entstehende Abwärme abzuleiten müssen entsprechende Kühlungen vorgesehen sein.

So müssen beispielsweise in Basisstationen Kühlaggregate eingebaut werden, deren ständiger Betrieb die Leistungsbilanz der Basisstation bei Einbezug der notwendigen Kühlleistung noch weiter verschlechtert. Typische Werte für den Wirkungsgrad von modernen Basisstationen liegen deshalb oft im einstelligen Prozentbereich.

Dabei kommen in der Regel symmetrische oder asymmetrischen Doherty Verstärker mit einer entsprechenden digitalen Vorverzerrung für Sendearchitekturen in Mobilfunk-Basisstationen zum Einsatz. Bei dieser Art von linearen Sendeeinrichtungen müssen der Leistungsverstärker als auch alle anderen Baugruppen im Signalpfad, in Hinblick auf eine einfache Vorverzerrung mit einer möglichst linearen Übertragungscharakteristik, entworfen werden.

Dies ist jedoch in den meisten Fällen in den oberen Dynamikbereichen nur zu Lasten des Wirkungsgrades möglich. Mit herkömmlich digital vorverzerrten Doherty-Verstärkern für Signale mit hohem Crest-Faktor können Wirkungsgradsteigerung gegenüber Leistungsendstufen im Klasse-AB Betrieb erreicht werden.

Um eine möglichst hohe Effizienz bereitzustellen, müsste ein sehr komplexes Verstärkermodell für eine Echtzeitimplementierung der digitalen Vorverzerrung entwickelt werden. Dieses müsste auch in der Lage sein Alterungseinflüsse bzw. Umgebungsvariablen zu berücksichtigen. Da dies zu komplex ist, kann das Potential des Doherty-Konzeptes nicht ausgereizt werden.

Andere Konzepte, wie z.B. LINC-Konzepte (Linear amplification with Nonlinear Components), welche eine Technik zur Verstärkung von amplitudenmodulierten Signalen mit nichtlinearen Verstärkern darstellt, verfügen nur über einen niedrigen Wirkungsgrad, bzw. weisen für den Fall von Multilevel LINC Systemen eine hohe Komplexität auf.

Durch die Verwendung von Versorgungsspannungs-Modulatoren reduziert sich der Wirkungsgrad der Gesamtanordnung durch die Verluste des oder der verwendeten Spannungsmodulatoren. Um diese Verluste gering zu halten, kann deshalb nur eine begrenzte Anzahl an Spannungspegeln, im Idealfall feste vordefinierte Werte, realisiert werden. Die geforderte Flexibilität bei hohem Wirkungsgrad für Multistandard Multiband Sender kann deshalb - wenn überhaupt - nur schwer realisiert werden.

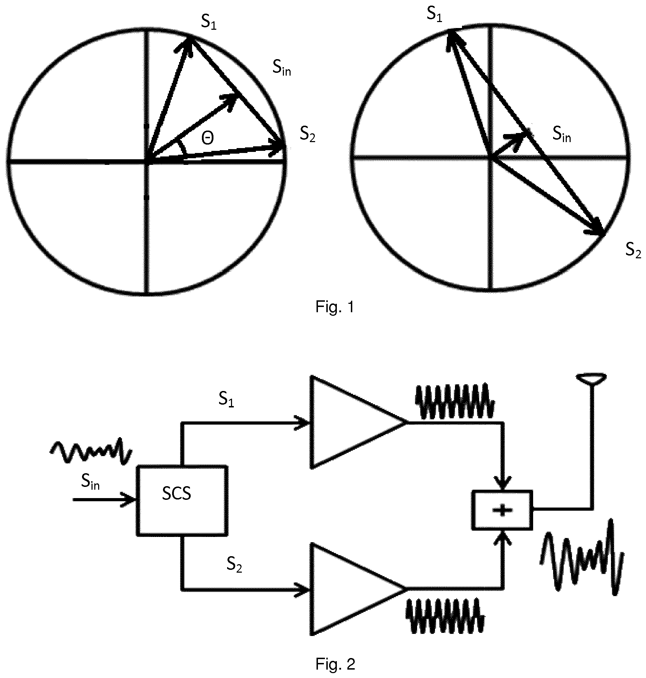

In LINC Transmittern, wie z.B. dem System aus EP 1 881 597 A1 oder dem Artikel "Multilevel Linc System Design for Power Efficiency Enhancement", KAI-YUAN JHENG ET AL, veröffentlicht in "2007 IEEE WORKSHOP ON "SIGNAL PROCESSING SYSTEMS", ISBN 978-1-4244-1221-1, Seiten 31 - 34, oft auch als "Outphasing- transmitter" bezeichnet, wird ein komplexes Eingangssignal in zwei phasenmodulierte Signale mit konstanter Hüllkurve so überführt, dass eine Vektoraddition der beiden Signale wieder das originale Eingangssignal ergibt. Die beiden phasenmodulierten Signale weisen also den gleichen Ausgangspegel auf. Dieses Prinzip ist als Phasordiagramm in Figur 1 dargestellt. Dabei ist zu erkennen, dass für größere Ausgangsleistungen (Beispiel links) der Outphasing-Winkel θ gering ist, während für sehr kleine Ausgangssignale der Outphasing-Winkel θ sich 180° annähert (Beispiel rechts).

Die beiden phasenmodulierten Signale können nun mit hocheffizienten gesättigten oder geschalteten Verstärkern verarbeitet werden und dabei der hohe Wirkungsgrad dieser Verstärker ausgenutzt werden. Das Blockschaltbild eines entsprechenden LINC Transmitters aus dem Stand der Technik ist in Figur 2 dargestellt. Für Spitzenausgangsleistung stellt diese Verstärkerarchitektur somit eine sehr effiziente Anordnung dar.

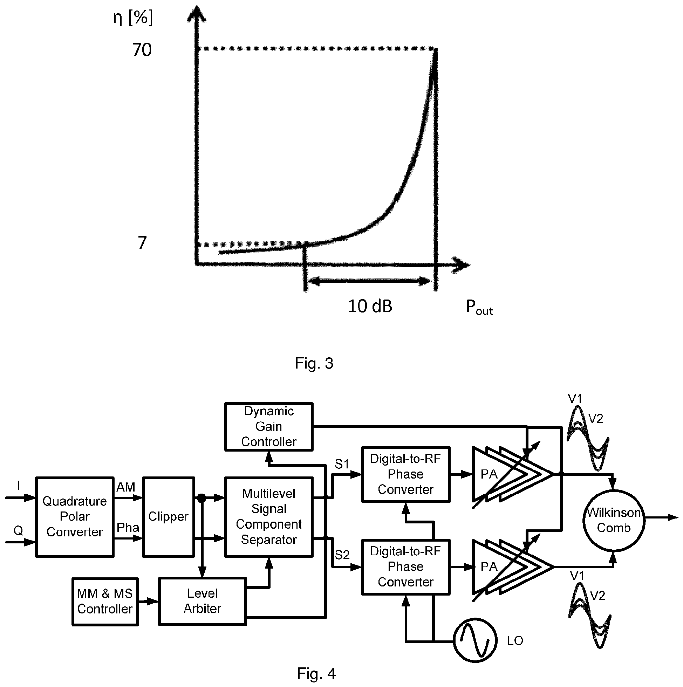

Wie in Figur 3 dargestellt, nimmt der Wirkungsgrad jedoch für Eingangssignale mit zunehmendem Crest-Faktor rapide ab. Die Energieeffizienz von LINC Anordnungen nimmt mit steigendem Back-off deutlich rascher ab als für lineare Verstärkeranordnungen wie z.B. Leistungsverstärker im Klasse-A oder Klasse-AB Betrieb. Dies ist darauf zurückzuführen, dass der Leistungsaddierer am Ausgang aus zwei Signalen mit maximaler Ausgangsleistung ein Signal mit geringerer Leistung synthetisiert. Dabei wird die überschüssige Leistung im Leistungsaddierer dissipiert. Dies führt in der Folge zu einem geringen Systemwirkungsgrad für niedrige Ausgangsleistungen.

Zwar könnte die Verwendung von nichtisolierenden Combinern eine Steigerung des Wirkungsgrades zur Verfügung stellen, jedoch ist dies nur um den Preis einer geringeren Linearität möglich.

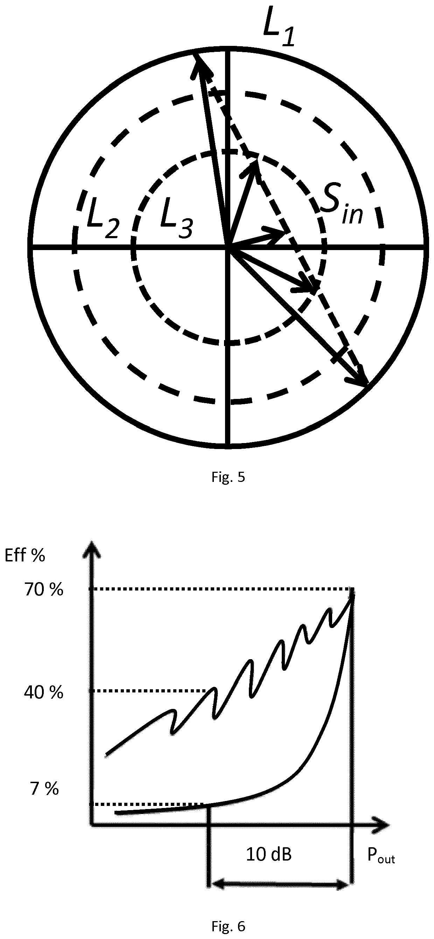

Eine gewisse Abhilfe bieten Multilevel LINC Anordnungen wie aus JUNQING GUAN ET AL: "System-level performance study of a multistandard outphasing transmitter using optimised multilevels", MICROWAVE SYMPOSIUM DIGEST (MTT), 2011, Seiten 1-4 bekannt und in Figur 4 gezeigt. Hier werden zusätzliche Ausgangspegel für die zwei Verstärker eingeführt, um bei der Synthese von Ausgangssignalen mit geringer Leistung den Outphasing-Winkel so gering wie möglich zu halten und somit die Verluste im Leistungsaddierer zu minimieren. Das Prinzip ist beispielhaft in einem Phasordiagramm in Figur 5 für ein Multilevel LINC System mit drei Ausgangspegeln dargestellt.

Wie in Figur 6 ersichtlich, wird durch Anpassung der Ausgangsleistung der Endstufen in Multilevel LINC (ML-LINC) Systemen sowohl der Gesamtwirkungsgrad als auch der Dynamikbereich bei der Verstärkung von Signalen mit hohem Crest-Faktor gegenüber einer reinen LINC Architektur verbessert.

Für die Erzeugung der gewünschten zusätzlichen Ausgangspegel können dabei verschiedene Techniken herangezogen werden.

Die Regelung der Ausgangsleistung in Abhängigkeit der augenblicklichen Eingangsleistung kann beispielsweise durch eine grobe Nachführung der Versorgungsspannung der gesättigten Ausgangsstufen mit oder ohne Regelung der Eingangsleistung, oder durch eine dynamische Skalierung der effektiven Weite der Ausgangstransistoren, oder durch Lastmodulation realisiert werden. Dabei werden beide Pfade des LINC Systems gleichzeitig und in gleicher Weise skaliert, d.h. es werden symmetrische Leistungspegel verwendet, wodurch sich der Aufbau sehr einfach halten lässt.

Die Verwendung asymmetrischer Leistungspegel ermöglicht bessere Wirkungsgrade, jedoch auf Kosten einer höheren Systemkomplexität.

Jedoch ist das richtige zeitliche Zusammentreffen der Ausgangsleistungsregelung mit dem zugehörigen phasenmodulierten Signal in Multilevel LINC Systemen für die Linearität und die Qualität des Signals von zentraler Bedeutung. Da verschiedene Informationsteile in unterschiedlichen Systempfaden verarbeitet werden, müssen Maßnahmen getroffen werden, damit die zwei Informationsteile zeitgleich am Ausgang wieder zusammengeführt werden und somit Signalverzerrungen minimiert werden, welche unter anderem zu unerwünschten Aussendungen führen.

Ausgehend von dieser Situation ist es Aufgabe der Erfindung eine neue Verstärkeranordnung zur Verfügung zu stellen, die einen hohen Wirkungsgrad ermöglicht bei geringer Komplexität. Weiterhin ist es eine Aufgabe der Erfindung eine neue Verstärkeranordnung bereitzustellen, die es ermöglicht Linearität und Energieeffizienz auch für unterschiedliche Modulationsarten individuell zu rekonfigurieren.

Die Aufgabe wird gelöst, durch eine Verstärkeranordnung gemäß Anspruch 1. Weitere vorteilhafte Ausgestaltungen sind insbesondere Gegenstand der abhängigen Ansprüche.

Nachfolgend wird die Erfindung näher unter Bezug auf die Figuren erläutert. In diesen zeigt:
Fig. 1 eine schematische Darstellung eines Phasordiagramms,
Fig. 2 ein schematisches Blockschaltbild eines LINC Transmitters gemäß Stand der Technik,
Fig. 3 eine schematische Darstellung des Wirkungsgrades einer LINC Anordnung gemäß dem Stand der Technik in Abhängigkeit der Systemausgangsleistung.
Fig. 4 ein schematisches Blockschaltbild eines Multilevel LINC Transmitters,
Fig 5 eine schematische Darstellung eines Phasordiagramms eines Multilevel LINC Transmitters gemäß Stand der Technik.
Fig. 6: eine mögliche Wirkungsgradsteigerung durch Verwendung von mehreren Pegeln in einem Multilevel LINC Transmitter,
Fig. 7 messtechnisch erfassbare Nachbarkanalleistung und Wirkungsgrad für ein WCDMA Signal als Funktion der verwendeten Multilevels,
Fig. 8: ein messtechnisch erfassbares Ausgangsspektrum eines WCDMA Signales in Abhängigkeit der verwendeten Anzahl Pegel.
Fig. 9: messtechnisch erfassbare Nachbarkanalleistung und Wirkungsgrad für ein 20 MHz breites LTE Signal als Funktion der verwendeten Multilevels.
Fig. 10: messtechnisch erfassbare Drain-Effizienz und Wirkungsgrad eines beispielhaften Doherty-Verstärker.
Fig. 11 ein schematischer Aufbau einer Verstärkeranordnung gemäß Ausführungsformen der Erfindung.

Die vorliegende Verstärkeranordnung ermöglicht einen vorteilhaften Kompromiss zwischen geforderter Linearität und erreichbarem Wirkungsgrad für die Verstärkung von digitalmodulierten Signalen bei gleichzeitig geringer Systemkomplexität zu erreichen. In der vorgestellten Verstärkeranordnung werden die sehr guten Linearitätseigenschaften des LINC Konzeptes mit dem hohen Wirkungsgrad von Doherty-Verstärkern vereint.

Durch die Verwendung von Doherty-Verstärkern an der Stelle von Schaltverstärkern als Endstufen ergeben sich erhebliche Vorteile auf Systemebene, welche zu einer deutlichen Vereinfachung des Gesamtsystems führen.

Zusätzlich entfallen mit diesen Modifikationen trotz oder gerade wegen der geringen Systemkomplexität sämtliche kritische Systemaspekte, wie z.B. die zeitliche Abstimmung von zwei unterschiedlichen Signalpfaden, während die Vorzüge von ML-LINC Systemen erhalten bleiben.

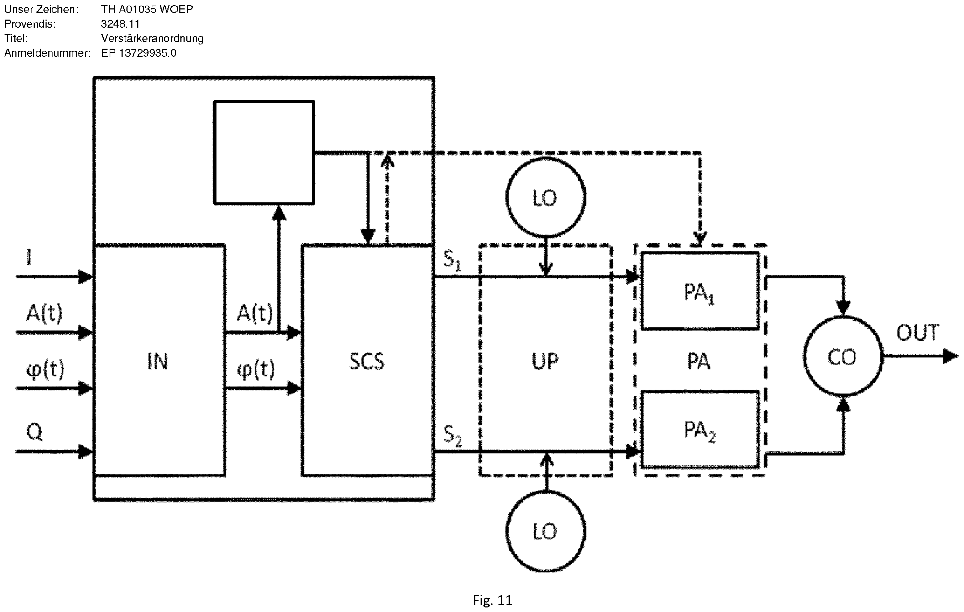

Eine Verstärkeranordnung gemäß der Erfindung wird nun nachfolgend in Bezug auf Figur 11 dargestellt. Dabei weist die Anordnung eine Eingangseinrichtung IN zur Entgegenahme von einer Repräsentanz eines Eingangssignales I, Q; A, phi auf. Dabei können beispielsweise nur I und Q erhalten werden. Dann kann aus I und Q unter Zuhilfenahme eines Quadratur-zu-Polarkoordinatenkonverters ein korrespondierendes Amplitudensignal A(t) und ein Phasensignal phi(t) erzeugt werden.

Weiterhin weist die Verstärkeranordnung gemäß der Erfindung einen Signalkomponenten-Separator SCS auf, wobei der Signalkomponenten-Separator SCS ein erstes komplexes Zwischenausgangssignal S₁ und ein zweites komplexes Zwischenausgangssignal S₂ auf Basis der Repräsentanz des Eingangssignales I, Q; A, phi erzeugt,

In der Figur ist dies auf Basis des Amplitudensignale A(t) und des Phasensignal phi(t) gezeigt. Jedoch können auch aus den I und Q Komponenten durch eine entsprechende Signalaufbereitung die entsprechenden Zwischenausgangssignale generiert werden.

Der Signalkomponenten-Separator stellt dabei eine Vielzahl von Amplitudenstufen zur Verfügung, wobei die Vielzahl von Amplitudenstufen so ausgewählt wird, dass eine Summe des ersten komplexen Zwischenausgangssignal S₁ und des zweiten komplexen Zwischenausgangssignal S₂ im Wesentlichen ein Abbild eines komplexen Eingangssignals entsprechend der Repräsentanz des Eingangssignales I, Q; A, phi darstellt und der Phasenwinkel zwischen dem ersten komplexen Zwischenausgangssignal S₁ und dem zweiten komplexen Zwischenausgangssignal S₂ klein ist,

In den Ausführungsformen der Erfindung stellt der Signalkomponenten-Separator SCS für das erste komplexe Zwischenausgangssignal S₁ und das zweite komplexe Zwischenausgangssignal S₂ zumindest teilweise unterschiedliche Amplitudenstufen zur Verfügung. Hierdurch kann der Dynamikbereich vergrößert werden.

D.h. es wird ein Mulitilevel-System zur Verfügung gestellt, wobei durch die Vielzahl der Amplitudenstufen der Winkel klein gehalten werden kann. Hierdurch sinkt die Verlustleistung bei einer anschließenden Zusammenführung und der Gesamtwirkungsgrad steigt.

Weiterhin weist die Verstärkeranordnung gemäß der Erfindung eine oder mehrere Verstärkereinrichtungen PA, PA₁, PA₂ zur Verstärkung der Signale in der Hochfrequenzlage auf. Dabei kann die Verstärkereinrichtung beispielsweise auf jedes der Zwischenausgangssignale in der Hochfrequenzlage angewendet werden, wie in Figur 11 gezeigt, oder aber die Verstärkereinrichtung kann auch auf die zusammengeführten Zwischenausgangssignale in der Hochfrequenzlage angewendet werden.

Weiterhin weist die Verstärkeranordnung gemäß der Erfindung eine Kombiniereinrichtung CO zum Zusammenführen der Signale auf.

In einer besonders bevorzugten Ausführungsform der Erfindung ist die Verstärkereinrichtung eine Doherty-Anordnung.

Die Kombiniereinrichtung CO ist bevorzugt eine isolierende Kombiniereinrichtung. Alternativ ist die Verwendung einer nichtisolierenden Kombiniereinrichtung CO vorgesehen. Diese erlaubt eine Steigerung des Wirkungsgrades, allerdings muss dann eine gewisse Einbuße bei der Linearität eingeplant werden.

Ohne Beschränkung der Allgemeinheit der Erfindung kann die Verstärkereinrichtung eine symmetrische oder eine asymmetrische Doherty-Verstärkeranordnung sein. Bei einer symmetrischen Doherty-Verstärkeranordnung sind die verwendeten (zwei) Transistoren vergleichbar dimensioniert wohingegen bei einer asymmetrischen Doherty-Verstärkeranordnung die verwendeten (zwei) Transistoren unterschiedlich dimensioniert sind. In aller Regel kann mit einer symmetrischen Doherty-Verstärkeranordnung ein Effizienzplateau von circa 6 dB erhalten werden während bei einer asymmetrischen Doherty-Verstärkeranordnung ein Effizienzplateau von circa 6 dB erhalten werden kann. Im Falle einer asymmetrischen Doherty-Verstärkeranordnung kann der Wirkungsgrad bzw. der Dynamikbereich verbessert werden.

Alternativ oder zusätzlich kann die Verstärkereinrichtung einen oder mehrere MehrwegDoherty-Verstärker oder Mehrstufen-Doherty-Verstärker aufweisen.

In einer Ausführungsform der Erfindung weist die Verstärkeranordnung eine Konversionseinrichtung UP zur Erzeugung von aufwärtsumgesetzten Signalen basierend auf dem ersten komplexen Zwischenausgangssignal S₁ und dem zweiten komplexen Zwischenausgangssignal S₂ auf, wobei die Konversionseinrichtung UP ein Aufwärtsmischer ist, und wobei die aufwärtsumgesetzten Signale der Verstärkereinrichtung PA; PA₁, PA₂ zugeführt werden.

In einer alternativen Ausführungsform der Erfindung weist die Verstärkeranordnung eine Konversionseinrichtung UP zur Erzeugung von aufwärtsumgesetzten Signalen basierend auf dem ersten komplexen Zwischenausgangssignal S₁ und dem zweiten komplexen Zwischenausgangssignal S₂ auf, wobei die Konversionseinrichtung UP einen Phasenmodulator mit einem Glied mit variabler Verstärkung oder variabler Dämpfung aufweist.

In einer Ausführungsform der Erfindung stellt der Signalkomponenten-Separator SCS weiterhin eine Begrenzung der maximalen Amplitude und oder minimalen Amplitude des ersten komplexen Zwischenausgangssignal S₁ und des zweiten komplexen Zwischenausgangssignal S₂ zur Verfügung. Hierdurch können Verzerrungen vermieden und der Gesamtwirkungsgrad gesteigert werden. Insbesondere eine Begrenzung der minimalen Amplitude ist für die Linearität als auch für den Wirkungsgrad von Bedeutung. Durch das Einführen einer minimalen Amplitude werden Nulldurchgänge vermieden und dadurch die Signalbandbreite reduziert. Zudem wird der Dynamikbereich vergrößert.

In einer Ausführungsform der Erfindung stellt die Verstärkeranordnung weiterhin eine Vorverzerrung zur Verfügung. Eine Vorverzerrung ermöglicht es vorhandene Nichtlinearitäten zu kompensieren und so die gewünschte Linearität zu erhalten. Hierdurch kann der Wirkungsgrad erhöht werden, da typischerweise -bei einem unkompensierten Betrieb die Nichtlinearität bei hohem Wirkungsgrad höher sein kann als das Übertragungssystem zulässt.

In einer Ausführungsform der Erfindung stellt der Signalkomponenten-Separator SCS weiterhin ein Signal zur Steuerung der dynamischen Verstärkung der Verstärkereinrichtung PA; PA₁, PA₂ zur Verfügung. Da der Signalkomponenten-Separator SCS das zu erreichende Zielsignal bezüglich seiner Amplitude bestimmen kann, kann so auch effektiv die Verstärkereinrichtung PA; PA₁, PA₂ eingestellt werden. Durch die Möglichkeit die Verstärkereinrichtung PA; PA₁, PA₂ einzustellen, kann der Wirkungsgrad der Verstärkereinrichtung PA; PA₁, PA₂ in einem günstigen Bereich mit hoher Linearität und Wirkungsgrad gehalten werden, wodurch der hohe Gesamtwirkungsgrad und die hohe Linearität der gesamten Verstärkeranordnung sicher gestellt wird.

Ausgehend von der hohen Linearität und des geringen Wirkungsgrades eines konventionellen LINC Systems mit isolierendem Combiner kann durch Erhöhung der Anzahl der Pegel in Multilevel LINC Transmittern die Energieeffizienz auf Kosten der Linearität gesteigert werden.

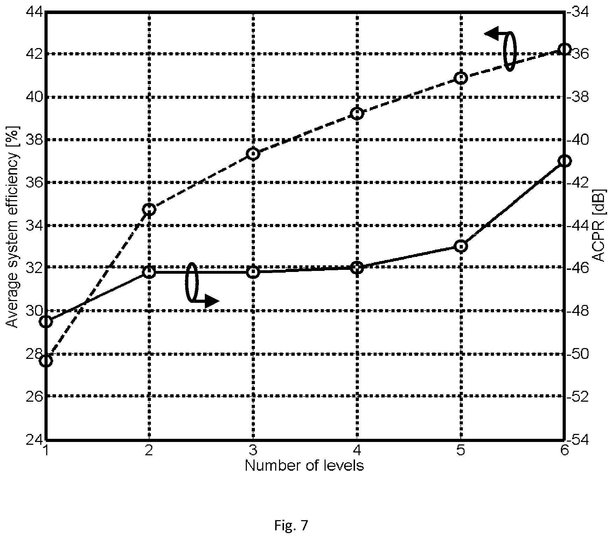

Dies ist in Figur 7 exemplarisch für ein 3.8 MHz breites WCDMA Signal dargestellt. Der Spitzenwirkungsgrad der verwendeten Verstärker ist 55 %.

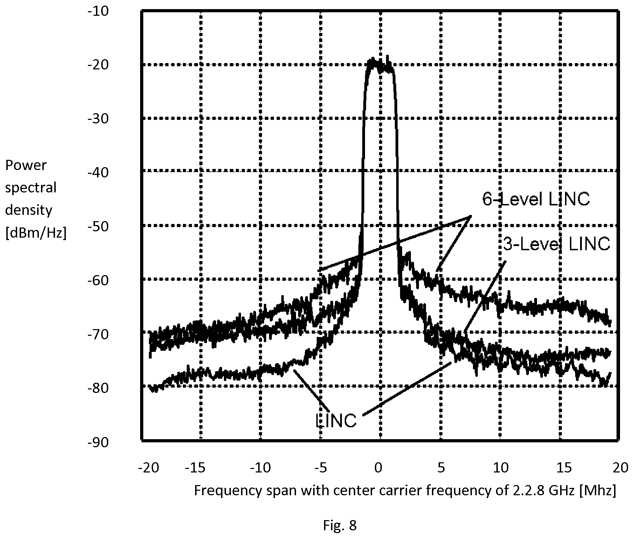

Das gemessene "Weit-ab-Rauschen" für dasselbe Signal ist in Figur 8 als Funktion der Anzahl optimierter Pegel abgebildet.

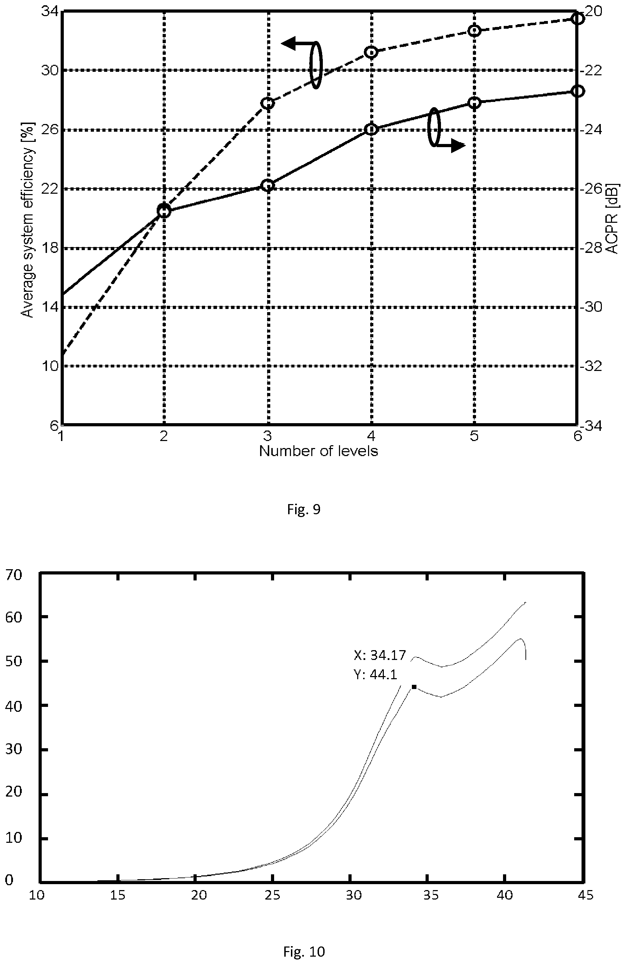

Mit derselben Anordnung können durch Anpassung der Systemparameter auch andere Mobilfunkstandards verarbeitet werden, d.h. die Verstärkeranordnung ist hoch flexibel und kann daher für eine Vielzahl von Übertragungssystemen verwendet werden. In Figur 9 sind die gemessene Nachbarkanalleistung und der Wirkungsgrad als Funktion der Anzahl der auf die Signalstatistik eines 20 MHz-breiten LTE Signals optimierten Pegel gezeigt. Auch hier beträgt der Spitzenwirkungsgrad der verwendeten Verstärker 55 %.

Bei den Figuren 7 bis 9 ist jeweils zu berücksichtigen, dass diese nicht auf einer phasenkohärente Aufwärtsmischung basieren. Die Auswirkungen davon machen sich besonders für Breitbandsignale wie das für die Messungen in Figur 9 verwendete 20 MHz LTE Signal durch ein überhöhtes Nachbarkanalrauschen bemerkbar. Unter Verwendung einer phasenkohärenten Frequenzumsetzung wird - selbst für eine große Anzahl an gewählten Pegel - die spektrale Emissionsmaske von Breitbandsignalen eingehalten.

Folglich kann mit der vorgestellten Anordnung ein breitbandiger, flexibler Multistandard- und Multiband-Transmitter mit hohem Wirkungsgrad realisiert werden.

Vergleicht man die Wirkungsgrade der Doherty-Verstärker in Figur 10, so entspricht die tiefere Kurve dem Wirkungsgrad, d.h. der Power Added Efficiency, während die höhere Kurve der Drain-Effizienz desselben Verstärkers entspricht, so zeigt dich, dass die erhaltenen mittleren Wirkungsgrade gemessen an dem Spitzenwirkungsgrad der Doherty-Endstufen von 55 % sehr hoch sind.

Die Erfindung ermöglicht also den Einsatz von effizienten Doherty-Verstärkern als End- und/oder als Treiberstufe in einer Multilevel LINC Anordnung.

Hierdurch wird eine digitale Linearisierung des gesamten Sendezuges über eine LINC Struktur bereitgestellt.

Durch diesen Ansatz können die Vorteile beider Technologien beibehalten werden, ohne sich die jeweiligen Nachteile einzuhandeln. Die vorgestellte Verstärkeranordnung stellt somit die Linearität eines herkömmlichen LINC bzw. Multilevel LINC Transmitters gepaart mit der Wirkungsgradsteigerung von symmetrischen/asymmetrischen Doherty-Verstärkern bereit.

Dabei kann zugleich die Systemkomplexität durch den Einsatz von Doherty-Verstärkern reduziert werden, da die Ausgangsleistungsregelung stufenlos nach dem Prinzip der aktiven Lastmodulation nach Doherty erfolgen kann.

Ein Hilfsverstärker, der Teil der Doherty-Konfiguration sein kann, kann anhand des am Eingang anliegenden Signals die Ausgangsleistung der Gesamtanordnung modulieren. Ein Hauptverstärker kann über den größtmöglichen Aussteuerbereich (bei symmetrischen Anordnungen 6 dB, bei asymmetrischen bis zu 12 dB und mehr) in Spannungssättigung betrieben werden und seine Last dermaßen angepasst werden, dass der Hauptverstärker gerade genügend Strom für die geforderte Ausgangsleistung in die Last treibt. Somit ergibt sich eine erhebliche Wirkungsgradsteigerung.

Bei der Steuerung der Ausgangsleistung durch eine derartige aktive Lastmodulation wird die Amplitudeninformation zusammen mit der Phaseninformation direkt an die Eingänge der Leistungsverstärker angelegt. Somit durchlaufen Amplituden- sowie Phasensignal den exakt identischen Pfad und keine Zeitverzögerung zwischen den beiden Signalen entsteht. Programmierbare Verzögerungsglieder und spezielle Versorgungsspannungsmodulatoren werden somit nicht benötigt, wodurch sich wiederum eine höhere Systembandbandbreite ergibt.

Das System vereinfacht sich dadurch wie in Figur 11 dargestellt. Anstelle des Phasenmodulators kann in diesem System ein herkömmlicher Aufwärtsmischer UP für die Frequenzumsetzung des amplituden- und phasenmodulierten Signals verwendet werden. Eine evtl. Begrenzung der Eingangssignalamplitude durch einen Clipper und eine digitale Vorverzerrung kann im digitalen Bereich implementiert werden, um die Systemperformanz weiter zu verbessern. Dabei ist die Vorverzerrung gegenüber einem Sender mit durchwegs linearen Baugruppen erheblich einfacher, da nur der Phasen- und Amplitudengang beider Pfade für wenige diskrete Punkte ausgeglichen werden muss. Zwischen den gewählten Punkten wird das System mittels Ausphasung (Outphasing), also über LINC, linearisiert.

Zusätzlich erreicht die vorgestellte Verstärkeranordnung einen deutlich höheren Wirkungsgrad für eine vergleichbare Linearität, da das System statt Schaltverstärker Doherty-Verstärker einsetzen kann. Zwar weisen Doherty-Verstärker im Unterschied zu gesättigten und geschalteten Verstärkern, wie sie in bisherigen Outphasing-Systemen verwendet werden, einen geringeren Spitzenwirkungsgrad auf, jedoch weisen Doherty-Verstärker deutlich höhere Effizienz über einen großen Dynamikbereich auf.

Durch die Verwendung von asymmetrischen Doherty-Anordnungen und/oder MehrwegDoherty-Verstärkeranordnungen können zudem Wirkungsgradsteigerungen erreicht werden, da diese Verstärkeranordnungen einen hohen Wirkungsgrad über einen Aussteuerbereich von deutlich über 6 dB aufweisen. Dadurch erreicht die vorgestellte Verstärkeranordnung hohe mittlere Wirkungsgrade für digitalmodulierte Breitbandsignale bei relativ geringer Systemkomplexität.

Die vorgestellte Verstärkeranordnung ermöglicht eine deutliche Reduktion der Systemkomplexität gegenüber herkömmlichen Systemen. Die vorgestellte Verstärkeranordnung verbessert Linearität und Wirkungsgrad gegenüber bekannten Systemen, speziell für Breitbandsignale mit hohem Crest-Faktor. Zudem erlaubt die vorgestellte Verstärkeranordnung eine einfache Anpassung des Systems für die Verstärkung von verschiedenen Übertragungsstandards sowie eine dynamische Optimierung des Wirkungsgrades und der Linearität für den gerade verwendeten Übertragungsstandard. Zudem erlaubt die vorgestellte Verstärkeranordnung eine Vereinfachung des Entwurfes von Doherty-Verstärkern und ermöglicht eine Erhöhung des Dynamikbereichs insbesondere im Vergleich zu bekannten LINC Transmittern. Bei der vorgestellten Verstärkeranordnung ist zudem eine Reduktion der Empfindlichkeit des Systems gegenüber Abweichungen (Mismatches) des Amplituden- und Phasengangs zwischen den beiden Pfaden gegeben. Somit sind eine große Einsparung bei den OPEX und CAPEX sowie eine signifikante Wirkungsgradsteigerung gegenüber bisherigen Systemen möglich.

Die vorgestellte Erfindung kann in den unterschiedlichsten Geräten Verwendung finden. So ist es möglich die Erfindung in Mobilfunk-Basisstationen als auch Mobilfunkstationen selbst und in Rundfunkstationen zu verwenden. Insbesondere ist die Erfindung zur Verwendung in Software Defined Radio Anwendungen geeignet.

## Patentansprüche

1. Verstärkeranordnung, wobei die Anordnung aufweist:
a. Eine Eingangseinrichtung zur Entgegenahme von einer Repräsentanz eines Eingangssignales (I, Q; A, phi),
b. Ein Signalkomponenten-Separator (SCS), wobei der Signalkomponenten-Separator (SCS) ein erstes komplexes Zwischenausgangssignal (S₁) und ein zweites komplexes Zwischenausgangssignal (S₂) erzeugt, wobei der Signalkomponenten-Separator das erste komplexe Zwischenausgangssignal (S₁) und das zweite komplexe Zwischenausgangssignal (S₂) auf Basis der Repräsentanz des Eingangssignales (I, Q; A, phi) erzeugt,
c. Wobei der Signalkomponenten-Separator (SCS) eine Vielzahl von Amplitudenstufen zur Verfügung stellt,
d. Wobei die Vielzahl von Amplitudenstufen so ausgewählt wird, dass eine Summe des ersten komplexen Zwischenausgangssignal (S₁) und des zweiten komplexen Zwischenausgangssignal (S₂) im Wesentlichen ein Abbild eines komplexen Eingangssignals entsprechend der Repräsentanz des Eingangssignales (I, Q; A, phi) darstellt und der Phasenwinkel zwischen dem ersten komplexen Zwischenausgangssignal (S₁) und dem zweiten komplexen Zwischenausgangssignal (S₂) klein ist,
e. Eine Verstärkereinrichtung (PA, PA₁, PA₂) zur Verstärkung der Signale in der Hochfrequenzlage, und
f. Eine Kombiniereinrichtung zum Zusammenführen der Signale,
g. wobei die Verstärkereinrichtung (PA, PA₁, PA₂) eine Doherty-Anordnung aufweist,
**dadurch gekennzeichnet, dass** der Signalkomponenten-Separator (SCS) für das erste komplexe Zwischenausgangssignal (S₁) und das zweite komplexe Zwischenausgangssignal (S₂) zumindest teilweise unterschiedliche Amplitudenstufen zur Verfügung stellt, wobei das erste komplexe Zwischenausgangssignal (S₁) und das zweite komplexe Zwischenausgangssignal (S₂) asymmetrische Leistungspegel aufweisen.

2. Verstärkeranordnung gemäß Anspruch 1, **dadurch gekennzeichnet, dass** die Kombiniereinrichtung eine isolierende Kombiniereinrichtung (CO) ist.

3. Verstärkeranordnung gemäß Anspruch 1, **dadurch gekennzeichnet, dass** die Kombiniereinrichtung eine nichtisolierende Kombiniereinrichtung (CO) ist.

4. Verstärkeranordnung gemäß einem der vorhergehenden Ansprüche, **dadurch gekennzeichnet, dass** die Verstärkereinrichtung (PA, PA₁, PA₂) eine asymmetrische Doherty-Verstärkeranordnung aufweist.

5. Verstärkeranordnung gemäß einem der vorhergehenden Ansprüche, **dadurch gekennzeichnet, dass** die Verstärkereinrichtung (PA, PA₁, PA₂) Mehrweg-Doherty-Verstärker oder Mehrstufen-Doherty-Verstärker aufweist.

6. Verstärkeranordnung gemäß einem der vorhergehenden Ansprüche, **dadurch gekennzeichnet, dass** die Verstärkeranordnung eine Konversionseinrichtung zur Erzeugung von aufwärtsumgesetzten Signalen basierend auf dem ersten komplexen Zwischenausgangssignal (S₁) und dem zweiten komplexen Zwischenausgangssignal (S₂) aufweist, wobei die Konversionseinrichtung ein Aufwärtsmischer ist, und wobei die aufwärtsumgesetzten Signale der Verstärkereinrichtung zugeführt werden.

7. Verstärkeranordnung gemäß einem der vorhergehenden Ansprüche 1 bis 5, **dadurch gekennzeichnet, dass** die Verstärkeranordnung eine Konversionseinrichtung zur Erzeugung von aufwärtsumgesetzten Signalen basierend auf dem ersten komplexen Zwischenausgangssignal (S₁) und dem zweiten komplexen Zwischenausgangssignal (S₂) aufweist, wobei die Konversionseinrichtung einen Phasenmodulator mit einem Glied mit variabler Verstärkung oder variabler Dämpfung aufweist.

8. Verstärkeranordnung gemäß einem der vorhergehenden Ansprüche, **dadurch gekennzeichnet, dass** der Signalkomponenten-Separator (SCS) weiterhin eine Begrenzung der maximalen und/oder minimalen Amplitude des ersten komplexen Zwischenausgangssignal (S₁) und des zweiten komplexen Zwischenausgangssignal (S₂) zur Verfügung stellt.

9. Verstärkeranordnung gemäß einem der vorhergehenden Ansprüche, **dadurch gekennzeichnet, dass** die Verstärkeranordnung weiterhin eine Vorverzerrung zur Verfügung stellt.

## Claims

1. Amplifier assembly, wherein the assembly comprises:
a. an input device for receiving a representation of an input signal (I, Q; A, phi),
b. a signal component separator (SCS), wherein the signal component separator (SCS) generates a first complex intermediate output signal (S₁) and a second complex intermediate output signal (S₂), wherein the signal component separator (SCS) generates the first complex intermediate output signal (S₁) and the second complex intermediate output signal (S₂) on the basis of the representation of the input signal (I, Q; A, phi),
c. wherein the signal component separator provides a plurality of amplitude levels,
d. wherein the plurality of amplitude levels is chosen so that a sum of the first complex intermediate output signal (S₁) and the second complex intermediate signal (S₂) is substantially a mapping of the complex input signal corresponding to the representation of the input signal (I, Q; A, phi), and the phase angle between the first complex intermediate output signal (S₁) and the second complex intermediate output signal (S₂) is small,
e. an amplifying device (PA, PA₁, PA₂) for amplification of the signals in the highfrequency layer, and.
f. a combining device for combining the signals,
g. whereby the amplifying device comprises a Doherty design,
**characterized in that** the signal component separator (SCS), for the first complex intermediate output signal (S₁) and the second complex intermediate output signal (S₂) comprises at least in part different amplitude steps, whereby the first complex intermediate output signal (S₁) and the second complex intermediate output signal (S₂) comprise asymmetric power levels.

2. Amplifier assembly according to claim 1, wherein the combining device is an isolating combining device (CO).

3. Amplifier assembly according to claim 1, wherein the combining device is a non-isolating combining device (CO).

4. Amplifier assembly according to one of the preceding claims, wherein the amplifying device (PA, PA₁, PA₂) comprises an asymmetrical Doherty amplifier assembly.

5. Amplifier assembly according to one of the preceding claims, wherein the amplifying device (PA, PA₁, PA₂) comprises multipath Doherty amplifiers or multilevel Doherty amplifiers.

6. Amplifier assembly according to one of the preceding claims, wherein the amplifier assembly comprises a conversion device for generating upward-converted signals based on the first complex intermediate output signal (S₁) and the second complex intermediate output signal (S₂), with the conversion device having an upward mixer and the upward-converted signals being taken to the amplifying device.

7. Amplifier assembly according to one of the preceding claims 1 to 5, wherein the amplifier assembly has a conversion device for generating upward-converted signals based on the first complex intermediate output signal (S₁) and the second complex intermediate output signal (S₂), with the conversion device having a phase modulator with one element with variable gain or variable attenuation.

8. Amplifier assembly according to one of the preceding claims, wherein the signal component separator (SCS) furthermore provides a limiting of the maximum amplitude and/or minimum amplitude of the first complex intermediate output signal (S₁) and the second complex intermediate output signal (S₂).

9. Amplifier assembly according to claim 1, wherein the amplifier assembly furthermore provides a predistortion.

## Revendications

1. Agencement d'amplificateur, l'agencement comportant :
a. un système d'entrée destiné à recevoir une représentation d'un signal d'entrée (I, Q ; A, phi),
b. un séparateur de composantes de signal (SCS), le séparateur de composantes de signal (SCS) générant un premier signal de sortie intermédiaire (S₁) complexe et un et un deuxième signal de sortie intermédiaire (S₂) complexe, le séparateur de composantes de signal générant le premier signal de sortie intermédiaire (S₁) complexe et le deuxième signal de sortie intermédiaire (S₂) complexe sur la base de la représentation du signal d'entrée (I, Q ; A, phi),
c. le séparateur de composantes de signal (SCS) mettant à disposition une pluralité de niveaux d'amplitude,
d. la pluralité de niveaux d'amplitude étant sélectionnée de telle sorte que la somme du premier signal de sortie intermédiaire (S₁) complexe et du deuxième signal de sortie intermédiaire (S₂) complexe représente sensiblement une reproduction d'un signal d'entrée complexe, en fonction de la représentation du signal d'entrée (I, Q ; A, phi) et l'angle de phase entre le premier signal de sortie intermédiaire (S₁) complexe et le deuxième signal de sortie intermédiaire (S₂) complexe étant petit,
e. un système d'amplificateur (PA, PA₁, PA₂), destiné à amplifier les signaux dans la position haute fréquence, et
f. un combinateur destiné à réunir les signaux,
g. le système d'amplificateur (PA, PA₁, PA₂) comportant un agencement Doherty,
**caractérisé en ce que** le séparateur de composantes de signal (SCS) pour le premier signal de sortie intermédiaire (S₁) complexe et le deuxième signal de sortie intermédiaire (S₂) complexe met à disposition des niveaux d'amplitude au moins en partie différents, le premier signal de sortie intermédiaire (S₁) complexe et le deuxième signal de sortie intermédiaire (S₂) complexe présentant des niveaux de puissance asymétriques.

2. Agencement d'amplificateur selon la revendication 1, **caractérisé en ce que** le combinateur est un combinateur (CO) isolant.

3. Agencement d'amplificateur selon la revendication 1, **caractérisé en ce que** le combinateur est un combinateur (CO) non isolant.

4. Agencement d'amplificateur selon l'une quelconque des revendications précédentes, **caractérisé en ce que** le système d'amplificateur (PA, PA₁, PA₂) comporte un agencement d'amplificateur Doherty asymétrique.

5. Agencement d'amplificateur selon l'une quelconque des revendications précédentes, **caractérisé en ce que** le système d'amplificateur (PA, PA₁, PA₂) comporte des amplificateurs Doherty multivoies ou des amplificateurs Doherty multiniveaux.

6. Agencement d'amplificateur selon l'une quelconque des revendications précédentes, **caractérisé en ce que** l'agencement d'amplificateur comporte un dispositif de conversion destiné à générer des signaux convertis à la hausse sur la base du premier signal de sortie intermédiaire (S₁) complexe et du deuxième signal de sortie intermédiaire (S₂) complexe, le dispositif de conversion étant un mélangeur élévateur et les signaux convertis à la hausse étant amenés au système d'amplificateur.

7. Agencement d'amplificateur selon l'une quelconque des revendications précédentes 1 à 5, **caractérisé en ce que** l'agencement d'amplificateur comporte un dispositif de conversion destiné à générer des signaux convertis à la hausse sur la base du premier signal de sortie intermédiaire (S₁) complexe et du deuxième signal de sortie intermédiaire (S₂) complexe, le dispositif de conversion comportant un modulateur de phase doté d'un organe à amplification variable ou à amortissement variable.

8. Agencement d'amplificateur selon l'une quelconque des revendications précédentes, **caractérisé en ce que** le séparateur de composantes de signal (SCS) met à disposition par ailleurs une limitation de l'amplitude maximale et/ou minimale du premier signal de sortie intermédiaire (S₁) complexe et du deuxième signal de sortie intermédiaire (S₂) complexe.

9. Agencement d'amplificateur selon l'une quelconque des revendications précédentes, **caractérisé en ce que** l'agencement d'amplificateur met à disposition par ailleurs une prédistorsion.
